# EUROPÄISCHE PATENTSCHRIFT

(11) **EP 2 358 483 B1**
(45) Veröffentlichungstag und Bekanntmachung des Hinweises auf die Patenterteilung: **08.04.2015**
(21) Anmeldenummer: 09756655.8
(22) Anmeldetag: 11.11.2009
(51) Int. Cl.: B05D 1/32, C23C 16/44, C23C 14/56, B05D 5/08, B05D 7/24

(54) **VORBEHANDLUNGSVERFAHREN FÜR BESCHICHTUNGSANLAGEN**
PRETREATMENT METHOD FOR COATING SYSTEMS
PROCÉDÉ DE PRÉTRAITEMENT POUR INSTALLATIONS DE REVÊTEMENT

(30) Priorität: 20.11.2008 US 116461 P
(43) Veröffentlichungstag der Anmeldung: 24.08.2011
(73) Patentinhaber: Oerlikon Surface Solutions AG, Trübbach, 9477 Trübbach (CH)
(72) Erfinder: MOOSBRUGGER, Arno, A-6971 Hard (AT); WALCH, Mario, FL-9496 Balzers (LI); KRASSNITZER, Siegfried, A-6800 Feldkirch (AT); KASEMANN, Stephan, A-6800 Feldkirch (AT); GWEHENBERGER, Jürgen, CH-7323 Wangs (CH)
(74) Vertreter: Kempkens, Anke
(86) Internationale Anmeldenummer: PCT/CH2009/000355
(87) Internationale Veröffentlichungsnummer: WO 2010/057323

(56) Entgegenhaltungen:
- WO-A1-2005/103327
- WO-A1-2007/064520
- DE-U1- 20 316 044
- GB-A- 2 158 368
- US-A- 4 748 049
- US-A- 4 895 630
- US-A- 5 622 565
- US-A1- 2002 086 553

## Beschreibung

### Technisches Gebiet auf das sich die Erfindung bezieht

Die Erfindung bezieht sich auf ein Reinigungsverfahren im Zusammenhang mit Beschichtungsanlagen, insbesondere im Zusammenhang mit Vakuumbeschichtunganlagen. Bei der Beschichtung werden in der Regel zwangsläufig in der Beschichtungskammer Oberflächen beschichtet deren Beschichtung nicht erwünscht ist. Solche Flächen können beispielsweise Teile der Kammer, sein sowie Teile der zu beschichtenden Substrate sowie Halterungs- und sonstige Nebenflächen sein. Nach einer oder mehrerer Beschichtungen müssen diese in der Regel mühevoll gereinigt werden. Dies ist insbesondere dann notwendig, wenn es bei den unerwünscht beschichteten Teile bei der Beschichtung auf deren Oberflächeneigenschaften, wie zum Beispiel elektrische Leitfähigkeit ankommt. Mit dem erfindungsgemässen Verfahren wird diese Reinigung stark vereinfacht. Im Rahmen dieser Erfindungsmeldung werden die unerwünschterweise beschichteten Flächen als Nebenflächen bezeichnet, während die erwünscht beschichteten Flächen als Zielflächen bezeichnet werden.

### Bisheriger Stand der Technik

Gemäss Stand der Technik ist es bekannt solche unerwünschten Beschichtungen mittels unterschiedlichen Methoden, wie zum Beispiel Sandstrahlen, Schleifen, Bürsten oder sogar mechanische Nachbearbeitung oder chemische Entschichtungsprozesse zu entfernen. Alle diese Verfahren sind gängige, breit in der Branche eingesetzte Praxis. Aufgrund der oftmals starken Haftung dieser unerwünschten Beschichtungen an den Nebenflächen ist deren Entfernung nahezu durchgehend sehr Zeitaufwändig. Einerseits. In manchen Fällen müssen Nebenflächen nach jedem Beschichtungsprozess (Charge) gereinigt werden. Einige Reinigungsverfahren, wie zum Beispiel das nasschemische Entschichten oder das Sandstrahlen erfordenr

Hinzu kommt, dass alle abrasiven Reinigungsverfahren (Sandstrahlen, Schleifen etc.) eine zusätzlichen starken Materialverschleiß für die behandelten Komponenten bedeuten. Dies führt zusätzlich zu hohen Unterhaltskosten (Austausch der verschlissenen Komponenten).

Ausserdem führt dieser Materialverschleiß zu verminderter Prozesssicherheit da hierbei unter Umständen für den Beschichtungsprozess relevante mechanische Toleranzen nicht mehr eingehalten werden.

### Technische Aufgabenstellung der vorliegenden Erfindung

Es wäre daher wünschenswert ein Verfahren zur Verfügung zu haben, welches es die Nachteile des Stand der Technik zumindest Teilweise überwindet. Konkret wäre es wünschenswert ein vereinfachtes Reinigungsverfahren für Nebenflächen zur Verfügung zu haben, welches sich zusätzlich mit erheblich weniger Zeitaufwand durchführen lässt und welches nicht zu Materialverschleiss der zu reinigenden Komponenten führt.

### Angabe der allgemeinen Lösung bzw. des Lösungsweges

Grundidee der vorliegenden Erfindung ist es, die Nebenflächen noch vor dem Beschichtungsprozess derart einer Vorbehandlung zu unterwerfen, dass beim darauffolgenden Beschichtungsprozess das die Haftung des Beschichtungsmaterials auf den Nebenflächen im Vergleich zur Haftung ohne Vorbehandlung stark reduziert ist. Auf diese Weise wird die Reinigung stark vereinfacht.

Eine solche erfindungsgemässe Vorbehandlung kann beispielsweise darin bestehen auf die Nebenflächen eine geeignete "Antihaftschicht" aufzubringen. Die Antihaftschicht zeichnet sich durch geringe Haftung auf den Nebenflächen aus. Da sich die "Antihaftschicht" nach der eigentlichen Beschichtung zwischen der Nebenfläche und dem im Beschichtungsprozess aufgetragenen Material befindet, wird das Anhaften des Beschichtungsmaterials wirksam verhindert. Je nach Art des Beschichtungsprozesses sollte die Antihaftschicht temperaturbeständig, elektrisch leitend und vakuumtechnisch unbedenklich sein. Insbesondere die vakuumtechnische Unbedenklichkeit bildet eine Vorraussetzung für PVD-Prozesse. Vorzugsweise sollte dass Aufbringen der Antihaftschicht keinen negativen Einfluss auf die Eigenschaften der eigentlichen Schicht auf den Zielflächen haben.

### Detaillierte Beschreibung der Erfindung

Die Erfindung wird nun detailliert anhand von Beispielen und mit Hilfe der Figuren erläutert.

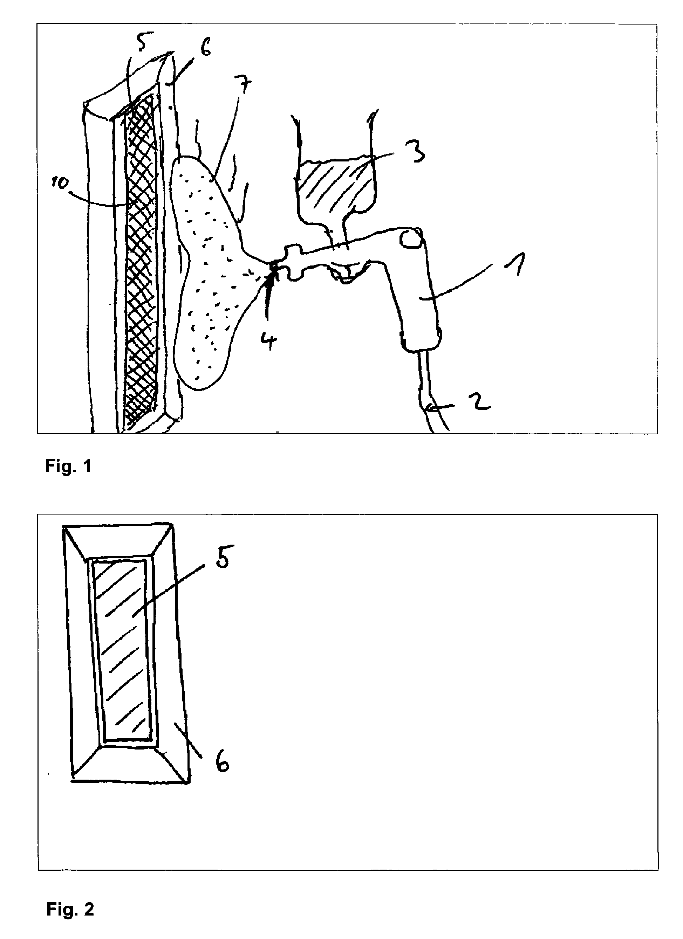

Figur 1 skizziert den Vorgang der erfindungsgemässen Vorbehandlung
Figur 2 skizziert ein Beispiel für die Verwendung einer Maskierungsschablone

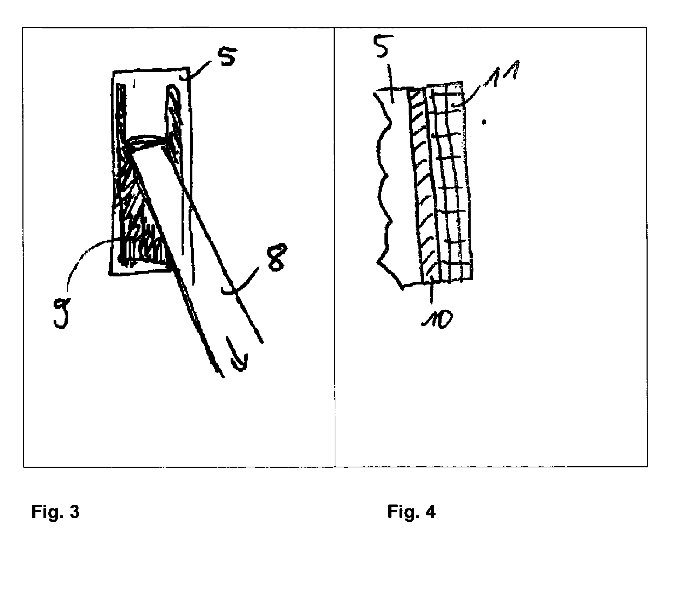

Figur 3 skizziert den erleichterten Reinigungsvorgang nach dem Beschichtungsprozess
Figur 4 skizziert den Querschnitt durch eine mit Antihaftschicht und Beschichtung versehene Oberfläche

Die nachfolgende Beschreibung beschränkt sich auf einen PVD-Prozess, wobei dadurch der Rahmen der Erfindung nicht auf einen solchen Prozess eingeschränkt sein soll.

Für eine solchen PVD-Prozess ist es wichtig, dass die Antihaftschicht vakuumtauglich ist. Dies bedeutet aber, dass in der Antihaftschicht keine Bindemitteln oder ähnliche Hilfsstoffen vorkommen.

Die Erfinder haben erkannt dass dies erreicht werden kann, wenn beim Aufbringen der Antihaftschicht auf die Nebenflächen eine Suspension aus Pulver in leicht flüchtigem Lösungsmittel in geeignetem Mischungsverhältnis zum Einsatz kommt. Das leicht flüchtige Lösungsmittel darf keine chemische Verbindung mit dem verwendeten Pulver oder der behandelten Oberfläche eingehen. Durch die Verwendung eines flüchtigen Lösungsmittels als Trägermedium der Suspension ist gewährleistet, dass das Lösungsmittel unmittelbar nach dem Sprühprozess bereits vollständig verdunstet ist und ausschließlich eine wenig haftende Pulverschicht auf der Oberfläche verbleibt. Als Lösungsmittel ist z.B. Isopropanol sehr gut geeignet.

Die Erfinder haben weiterhin erkannt, dass sich reines Graphit als Pulvermaterial eignet. Graphitpulver ist insbesondere im Vakuum genügend temperaturbeständig, elektrisch leitfähig, vakuumtauglich. und Antihaft-Eigenschaften erfüllt und darum im PVD-Prozess eingesetzt werden kann.

Der Auftrag erfolgt z.B. durch Aufsprühen mittels Spritzpistole. Dies kann ohne Gasunterstützung erfolgen oder mit Gasunterstützung. Im letzteren Fall eignet u.a. sich Luft Stickstoff oder auch CO₂. Die beim Spritzverfahren relevanten Einflussgrößen (z.B. Spritzdruck, Düsengröße der Pistole, Mischungsverhältnis der Suspension, Spritzabstand und -dauer) können in weiten Bereichen angepasst werden, um für eine Vielzahl von Anwendungen einen homogenen Schichtauftrag in geeigneter Dicke zu gewährleisten. Je nach Anwendung sind auch andere Auftragsverfahren möglich (Streichen, Tauchen, etc.).

Die Antihaftschicht gewährleistet, dass das während des PVD-Prozesses auf die behandelten Nebenflächen aufgetragene Beschichtungsmaterial nach dem PVD-Prozess durch einfaches Absaugen und/oder Abwischen im Wesentlichen vollständig entfernt werden kann. Eine weitere Nachbehandlung ist nicht erforderlich, die Nebenflächen können umgehend wieder mit einer neuen Antihaftschicht für den nachfolgenden Einsatz versehen werden.

Aufgrund der überragend guten Wirksamkeit und der Einfachheit in der Anwendung sind vielfältige Anwendungen beispielsweise im Umfeld des PVD-Prozesses denkbar:

Im Zusammenhang mit der Lichtbogenverdampfung kommen häufig sogenannte Confinement-Ringe zum Einsatz. Diese umgeben das das Beschichtungsmaterial aufweisende Target der Verdampfungsquelle und sorgen dafür, dass der Lichtbogen auf den Bereich der Targetoberfläche eingeschränkt bleibt. Aufgrund ihrer Nähe zum Targetmaterial unterliegen sie einem starken Materialauftrag beim PVD-Beschichtungsprozess und deren zu deren Reinigung waren bisher extrem agressive Methoden wie z.B. Sandstrahlen oder gar spanende Nachbearbeitung erforderlich. Durch das erfindungsgemässe Aufbringen des Graphitpulvers bleibt die notwendige elektrische Leitfähigkeit erhalten. Das während des PVD-Prozesses aufgebrachte Beschichtungsmaterial kommt auf die Graphitschicht zu liegen. Die Graphitschicht inklusive Belag lässt sich in einfacher Weise vom Confinement-Ring entfernen.

Ähnliches gilt für Substrathalter, die die zu beschichtenten Substrate während des Beschichtungsprozesses haltern. Aufgrund ihre räumlichen nahe zu den zu beschichtenden Substraten werden auch diese stark beschichtet. Nach der Beschichtung mussten die Substrathalter bisher mit Sandstrahlen zeitintensiv und damit kostenintensiv behandelt werden Sandstrahlen führt zu hohem Verschleiss. Neben der verminderten Prozesssicherheit mussten die teuren Halterungen daher häufig ersetzt werden. Werden Substrahalter erfindungsgemäss mit einer antihaftschicht vorbehandelt, so lassen diese sich nach dem PVD-Prozess einfach und schnell und ohne Verschleiss reinigen.

Entsprechendes gilt für das Karusell und die Bedampfungsschutzbleche einer PVD-Anlage. Umfasst die Anlage zusätzlich Anoden zur Bereitstellung einer Plasmaentladung, beispielsweise Sputterquellen, Niedervoltbogenentladungen und Ätzeinrichtungen, so lassen auch diese sich vorteilsbringend vor einem Beschichtungsschritt durch Aufbringen einer Antihaftschicht vorbehandeln.

Als konkretes Ausführungsbeispiel wird im Folgenden das zur Reinigung von beschichteten Anodenflächen, die Teil einer in der Beschichtungsanlage vorgesehen Ätzvorrichtung sind, angewandte erfindungsgemässe Verfahren im beschrieben.

Das sich hierbei darstellende Problem liegt darin, dass bei jedem PVD-Prozess die Anodenfläche stark mit fest haftendem Beschichtungsmaterial belegt ist. Wird in nachfolgenden Beschichtungsprozessen hierauf weiter beschichtet, so ergibt sich mit der Zeit eine sehr dicke und extrem schwer (zeitaufwändig) zu entfernende Ablagerung.

Werden elektrisch schlecht oder nichtleitende Schichten beschichtet so können die elektrisch oder nicht leitenden Ablagerungen auf der Anode dazu führen das bereits nach einem Beschichtungsprozess die Funktion der Anode nicht mehr gewährleistet werden kann, so dass bei solchen Prozessen die Reinigung der Anode nach jeder Charge zwingend erforderlich ist.

Um diese Reinigung durchzuführen wird beispielsweise folgendermassen vorgegangen.

Ausgangspunkt ist eine Anode, frei von Ablagerungen und Rückständen, d.h. die "jungfrauliche" Anode noch vor dem ersten Beschichtungsprozess oder nach einer Reinigungsbehandlung.

In einem ersten Schritt wird im Beispiel die unmittelbare Umgebung der mit einer Antihaftschicht zu beschichtenden Oberfläche der Anode, die in diesem Fall eine Nebenfläche gemäss der in dieser Beschreibung festgelegten Definition darstellt, abgedeckt und/oder maskiert. Hier kommt beispielsweise eine Blechschablone mit angepasstem Ausschnitt und geeigneter Geometrie in Frage. Die Schablone stellt sich dass lediglich die gewünschten Bereiche mit Antihaftschicht versehen werden.

In einem zweiten Schritt wird im Beispiel die Antihaftschicht im Spitzverfahren mit einer Spritzpistole aufgetragen, Hiebei wird eine das Antihaftschichtmaterial enthaltende Suspension auf die maskierte Anode aufgespritzt.

Zum Erstellen der aufzusprühenden Suspension wurde Graphitpulver in Isopropanol eingebracht. Im beschriebenen Beispiel handelt es sich bei der Anode um eine vertikal angebrachte Metalloberfläche. Daher ist darauf zu achten, dass Spritzabstand und Auftragsstärke so gewählt werden, dass ein Herunterrinnen von überschüssigem Lösungsmittel auf der Oberfläche vermieden wird. Dabei ist sehr vorteilhaft, wenn das leicht flüchtige Lösungsmittel im Aerosol bereits zwischen Spritzdüse und zu behandelnder Oberfläche weitgehend verdunstet kann. So ergibt sich eine optimale Bedeckung durch Graphitpulver. Hierfür spielt allerdings auch das Mischungsverhältnis von Lösungsmittel und Graphitpulver eine Rolle. Um ein Herunterrinnen zu vermeiden, sollte möglichst viel Graphitanteil vorhanden sein. Allerdings muss auch darauf geachtet werden, dass die Düse der Spritzpistole nicht verstopft. Als geeignet haben sich 50ml bis 150ml IPA auf 10g Graphitpulver erwiesen. Bevorzugt werden 100ml Isopropanol (IPA) auf 10g Graphitpulver verwendet.

Das verwendete Graphitpulver sollte weitgehend ohne Beimischungen von Bindemitteln oder anderen Additiven sein. Im vorliegenden Beispiel wurde eine Reinheit von 99.9% verwendet. Für die Korngrösse des Graphitpulvers haben sich 0.2µm bis 150µm als Maximalgrösse als günstig erwiesen. Vorteilhafterweise wird ein Graphitpulver eingesetzt, dessen Körner nicht grösser als 20µm sind.

Als Spritzpistole wurde eine handelsübliche Fliessbecher-Spritzpistole eingesetzt. Die Düsengrösse liegt beispielsweise zwischen 0.3mmm und 2mm und beträgt vorzugsweise 0.8mm.

Als Medium zum Antrieb des Spritzvorgangs wird Pressluft bei einem Druck zwischen 0.2bar und 1.0 bar, vorzugsweise zwischen 0.5bar und 0.7bar verwendet. Die Pressluft sollte entölt und möglichst partikelfrei sein um keiner Verschmutzung in die Suspesion und damit in die Antihaftschicht einzutragen. Es ist insbesondere darauf zu achten, dass die Pneumatik der Pistole nicht Verschmutzungen einführt.

Vor jeder Anwendung wird die Suspension homogenisiert. Dies kann durch schütteln, rütteln, durch Ultraschallbehandlung oder andere, dem Fachmann bekannte Methoden geschehen.

Es wird ein Sprühabstand zwischen 50mm und 250mm, idealerweise zwischen 100mm und 200mm verwendet. Wie bereits oben erwähnt ist ein grosser Sprühabstand insofern vorteilhaft als dass dem Lösungsmittel während der Flugzeit bereits die Möglichkeit gegeben wird, sich zu verflüchtigen. Ein zu grosser Abstand führt allerdings zu einer zu breiten räumlichen Streuung.

Die aufzutragende Schichtdicke der Antihaftschicht liegt im Beispiel zwischen 0.05mm und 2.0mm. Im vorliegenden Beispiel hat sich das Kriterium "optisch flächendeckend" als tauglich und aufgrund seiner Einfachheit als vorteilhaft erwiesen. Zumindest wenn die Nebenflächen nicht selbst Graphitoberflächen sind, lässt sich dies aufgrund der optischen Eigenschaften des Graphitpulvers gut durchführen. Das Aufbringen der Antihaftschicht erfolgt im Beispiel in mehreren und vorteilhafterweise gleichmässig geführten Spritzgängen.

Nach dem Aufbringen der Antihaftschicht ist vorzugsweise folgendes zu beachten: Da die Pulverschicht im Wesentlichen durch Adhäsionskräfte auf der Oberfläche haftet, sollten nach dem Aufsprühen Berührungen der beschichteten Nebenflächen möglichst vermieden werden. Daher ist es vorteilhaft - wo möglich - die Komponenten im fertig eingebauten Zustand zu behandeln oder entsprechend geeignete Vorrichtunge und/oder Werkzeuge ("Handlingshilfen") zu verwenden, so dass eine Verletzung der Antihaftschicht vermieden wird.

In einem dritten Schritt wird die zur Maskierung verwendete Blechschablone entfernt. Es sei nochmals darauf hingewiesen dass es nicht in jedem Fall einer solchen Maskierung bedarf, diese allerdings im Beispiel zur Anwendung kam.

Damit ist die Vorbehandlung abgeschlossen und die eigentliche PVD-Beschichtung kann in üblicher Weise durchgeführt werden. D.h. die Beschichtungskammer wird mit Werkstücken chargiert, die Kammer wird geschlossen und abgepumpt, die Beschichtung, beispielsweise Lichtbogenverdampfen, wird durchgeführt und die Beschichtungskammer wird anschliessend belüftet und geöffnet. Dabei hat die erfindungsgemässe Vorbehandlung der Anode, keinen nachteiligen Einfluss auf die Beschichtung.

Nach dem Öffnen der Beschichtungskammer wird die Antihaftschicht zusammen mit den auf ihr abgelegten Ablagerungen einfach abgesaugt, beispielsweise mittels eine Industriestaubsaugers. Wo erforderlich oder gewünscht kann die Anode auch noch mit Reinigungsalkohol abgewischt werden.

Vor dem nächsten Beschichtungsprozess wird die Anode wiederum entsprechend der Schritte 1 bis 3 vorbehandelt.

Idealerweise wird diese Prozedur nach jedem Beschichtungsprozess durchgeführt. Allerdings ist es auch möglich, auf das Absaugen der Antihaftschicht nach einem Beschichtungsvorgang zu verzichten und die Antihaftschicht lediglich nach mehreren Beschichtungszyklen zu erneuern.

Die Erfindung wurde beispielhaft anhand eine PVD-Beschichtungsanlage und der Vorbehandlung einer in der Vakuumkammer angeordneten IET-Anode beschrieben (ITE = Innova etching technology). In diesem Beispiel konnte der Reinigungsaufwand von bisher 20 Minuten auf wenige Minuten reduziert werden. Ausserdem wird durch das erfindungsgemässe Vorgehen die Anode geschont. Die erfindungsgemässe Vorbehandlung kann bei anderen Beschichtungsverfahren, insbesonder bei anderen Vakuumbeschichtungsverfahren wie zum Beispiel vorteilhaft angewendet werden. Falls notwendig könnte dann das Material der Anthaftungsschicht angepasst werden.

Weitere Anwendungsgebiete wurden bereits angesprochen. Insbesondere kann die Erfindung aber auch Vorteilhaft bei zu beschichtenden Substraten angewendet werden, wenn beispielsweise lediglich ein Teil der Substratoberfläche beschichtet werden soll. Bisher mussten die nicht zu Beschichtenden Oberflächenanteile der Substrate durch die Halterungen abgeschirmt werden. Mittels des erfindungsgemässen Vorgehens lassen sich demgegenüber die nicht zu Beschichtenden Teile der Substratoberfläche mit einer Antihaftschicht bedecken, die nach der Beschichtung in einfacher Weise abgesaugt und/oder abgewischt werden kann.

Für häufig wiederkehrende, gleichartige Antihaftschichtbehandlungen (z.B. Karusselle, Substrathalter, Substrate etc.) ist in einer Weiterbildung der vorliegenden Erfindung der Einsatz einer automatisch arbeitenden Sprüheinrichtung vorteilhaft.

Grob lässt sich die vorliegende Erfindung mit folgenden Punkten zusammenfassen:
Punkt 1: Vorbehandlungsverfahren für Beschichtungsverfahren, dadurch gekennzeichnet dass Nebenflächen einer Beschichtungsanlage noch vor dem Beschichtungsprozess derart einer Vorbehandlung unterworfen werden, dass beim darauffolgenden Beschichtungsprozess die Haftung des Beschichtungsmaterials auf den Nebenflächen im Vergleich zur Haftung ohne Vorbehandlung wesentlich herabgesetzt ist.
Punkt 2: Verfahren nach Punkt 1, dadurch gekennzeichnet, dass im Zuge der Vorbehandlung eine Antihaftschicht auf die Nebenflächen aufgebracht wird.
Punkt 3: Verfahren nach Punkt 2, dadurch gekennzeichnet, dass die Antihaftschicht eine Suspension aus Pulver in flüchtigem Lösungsmittel, vorzugweise leicht flüchtigem Lösngsmittel umfasst.
Punkt 4: Verfahren nach Punkt 3, dadurch gekennzeichnet, dass das Pulvermaterial Graphitpulver, vorzugsweise im Wesentlichen reines Graphitpulver ist.
Punkt 5: Verfahren nach einem der Punkte 2 bis 4, dadurch gekennzeichnet, dass die Anihaftschicht mittels einer Spritzpistole aufgesprüht wird.
Punkt 6: Verfahren welches ein Vorbehandlungsverfahren gemäss einem der Punkte 2 bis 5 umfasst, sowie ein darauffolgendes Beschichtungsverfahren, dadurch gkennzeichnet, dass nach einem oder mehreren Beschichtungszyklen die Antihaftschicht entfernt wird.

### Bezugszeichen für die Figuren:

1. Fließbecher-Spritzpistole
2. Druckluftzuführung
3. Suspension
4. Spritzdüse
5. Nebenfläche
6. Maskierungsschablone
7. Sprühnebel
8. Staubsaugerdüse
9. Mit Ablagerungen beaufschlagte Antihaftschicht
10. Antihaftschicht
11. Ablagerungen aus PVD-Prozess

## Patentansprüche

1. Vorbehandlungsverfahren für Beschichtungsverfähren, wobei Nebenflächen einer Beschichtungsanlage noch vor dem Beschichtungsprozess derart einer Vorbehandlung unterworfen werden, dass beim darauffolgenden Beschichtungsprozess die Haftung des Beschichtungsmaterials auf den Nebenflächen im Vergleich zur Haftung ohne Vorbehandlung wesentlich herabgesetzt ist, und wobei
im Zuge der Vorbehandlung eine Antihaftschicht auf die Nebenflächen aufgebracht wird, wobei
die Antihaftschicht eine Suspension aus Pulver in flüchtigem Lösungsmittel, vorzugweise leicht flüchtigem Lösungsmittel umfasst,
**dadurch gekennzeichnet, dass** das Pulvermaterial Graphitpulver, vorzugsweise im Wesentlichen reines Graphitpulver ist.

2. Verfahren nach Anspruch 1, **dadurch gekennzeichnet, dass** die Anihaftschicht mittels einer Spritzpistole aufgesprüht wird.

3. Verfahren welches ein Vorbehandlungsverfahren gemäss einem der Ansprüche 1 und 2 umfasst, sowie ein darauffolgendes Beschichtungsverfahren, dadurch gkennzeichnet, dass nach einem oder mehreren Beschichtungszyklen die Antihaftschicht entfernt wird.

## Claims

1. Pre-treatment method for coating processes, wherein secondary surfaces of a coating system are subjected even prior to the coating process to a pre-treatment such that during the subsequent coating process the adhesiveness of the coating material on the secondary surfaces is considerably reduced in comparison with adhesiveness without pre-treatment, and wherein, in the course of the pre-treatment, an anti-adhesive layer is applied onto the secondary surfaces, wherein the anti-adhesive layer comprises a suspension of powder in a volatile solvent, preferably lightly volatile solvent, **characterized in that** the powder material is graphite powder, preferably essentially pure graphite powder.

2. Method according to claim 1 **characterized in that** the anti-adhesive layer is sprayed by means of a spray gun.

3. Method comprising a pre-treatment method according to one of the claims 1 and 2 as well as a subsequent coating method, **characterized in that** after one or several coating cycles the anti-adhesive layer is removed.

## Revendications

1. Procédé de traitement préalable pour des procédés de revêtement, dans lequel des surfaces secondaires d'une installation de revêtement sont soumises à un traitement préalable encore avant le processus de revêtement d'une telle manière que dans le processus de revêtement suivant l'adhésion du matériau de revêtement sur les surfaces secondaires est sensiblement réduite en comparaison de l'adhésion sans traitement préalable, et dans lequel au fil du traitement préalable une couche antiadhésive est appliquée sur les surfaces secondaires, dans lequel
la couche antiadhésive comprend une suspension de poudre dans solvant volatil, préférablement solvant légèrement volatil,
**caractérisé par le fait que** le matériau en poudre est la poudre de graphite, préférablement la poudre de graphite pure.

2. Procédé selon la revendication 1, **caractérisé par le fait que** la couche antiadhésive est appliquée au moyen d'un pistolet pulvérisateur.

3. Procédé comprenant un procédé de traitement préalable selon l'une des revendications 1 et 2, ainsi qu'un procédé de revêtement suivant, **caractérisé par** le fait la couche antiadhésive est enlevée après un ou plusieurs cycles de revêtement.
